# EUROPEAN PATENT APPLICATION

(11) **EP 1 845 130 A2**
(43) Date of publication of application: **17.10.2007**
(21) Application number: 07251536.4
(22) Date of filing: 10.04.2007
(51) Int. Cl.: C08L 63/00, C08L 61/06, C08G 59/00, H01L 23/29

(54) **Hydrophobic crosslinkable compositions for electronic applications**

(30) Priority: 10.04.2006 US 401150; 10.04.2006 US 401149
(71) Applicant: E.I. DUPONT DE NEMOURS AND COMPANY, Wilmington, Delaware 19898 (US)
(72) Inventor: Dueber, Thomas E., Wilmington, Delaware 19801 (US); Summers, John D., Chapel Hill, North Carolina 27514 (US); Borland, William J., Chapel Hill, North Carolina 27517 (US); Renovales, Olga L., Apex, North Carolina 27523 (US); Majumdar, Diptarka, Cary, North Carolina 27519 (US); Amey, Daniel Irwin Jr., Durham, North Carolina 27705 (US)
(74) Representative: Towler, Philip Dean

(57) **Abstract**

Compositions comprising: an epoxy containing cyclic olefin resin with a water absorption of 2% or less; one or more phenolic resins with water absorption of less than 2% or less; an epoxy catalyst; optionally one or more of an electrically insulated filler, a defoamer and a colorant and one or more organic solvents. The compositions are useful as encapsulants and have a cure temperature of 190°C or less.

## Description

### FIELD OF THE INVENTION

This invention relates to compositions, and the use of such compositions for protective coatings. In one embodiment, the compositions are used to protect electronic device structures, particularly embedded fired-on-foil ceramic capacitors, from exposure to printed wiring board processing chemicals and for environmental protection.

### BACKGROUND OF THE INVENTION

Electronic circuits require passive electronic components such as resistors, capacitors, and inductors. A recent trend is for passive electronic components to be embedded or integrated into the organic printed circuit board (PCB). The practice of embedding capacitors in printed circuit boards allows for reduced circuit size and improved circuit performance. Embedded capacitors, however, must meet high reliability requirements along with other requirements, such as high yield and performance. Meeting reliability requirements involves passing accelerated life tests. One such accelerated life test is exposure of the circuit containing the embedded capacitor to 1000 hours at 85% relative humidity, 85°C under 5 volts bias. Any significant degradation of the insulation resistance would constitute failure.

High capacitance ceramic capacitors embedded in printed circuit boards are particularly useful for decoupling applications. High capacitance ceramic capacitors may be formed by "fired-on-foil" technology. Fired-on-foil capacitors may be formed from thick-film processes as disclosed in U.S. Patent Number 6,317,023B1 to Felten or thin-film processes as disclosed in U.S. Patent Application 20050011857 A1 to Borland et al.

Thick-film fired-on-foil ceramic capacitors are formed by depositing a thick-film capacitor dielectric material layer onto a metallic foil substrate, followed by depositing a top copper electrode material over the thick-film capacitor dielectric layer and a subsequent firing under copper thick-film firing conditions, such as 900-950°C for a peak period of 10 minutes in a nitrogen atmosphere.

The capacitor dielectric material should have a high dielectric constant (K) after firing to allow for manufacture of small high capacitance capacitors suitable for decoupling. A high K thick-film capacitor dielectric is formed by mixing a high dielectric constant powder (the "functional phase") with a glass powder and dispersing the mixture into a thick-film screen-printing vehicle.

During firing of the thick-film dielectric material, the glass component of the dielectric material softens and flows before the peak firing temperature is reached, coalesces, encapsulates the functional phase, and finally forms a monolithic ceramic/copper electrode film.

The foil containing the fired-on-foil capacitors is then laminated to a prepreg dielectric layer, capacitor component face down to form an inner layer and the metallic foil may be etched to form the foil electrodes of the capacitor and any associated circuitry. The inner layer containing the fired-on-foil capacitors may now be incorporated into a multilayer printed wiring board by conventional printing wiring board methods.

The fired ceramic capacitor layer may contain some porosity and, if subjected to bending forces due to poor handling, may sustain some microcracks. Such porosity and microcracks may allow moisture to penetrate the ceramic structure and when exposed to bias and temperature in accelerated life tests may result in low insulation resistance and failure.

In the printed circuit board manufacturing process, the foil containing the fired-on-foil capacitors may also be exposed to caustic stripping photoresist chemicals and a brown or black oxide treatment. This treatment is often used to improve the adhesion of copper foil to prepreg. It consists of multiple exposures of the copper foil to caustic and acid solutions at elevated temperatures. These chemicals may attack and partially dissolve the capacitor dielectric glass and dopants. Such damage often results in ionic surface deposits on the dielectric that results in low insulation resistance when the capacitor is exposed to humidity. Such degradation also compromises the accelerated life test of the capacitor.

An approach to rectify these issues is needed. Various approaches to improve embedded passives have been tried. An example of an encapsulant composition used to reinforce embedded resistors may be found in U.S. Patent 6,860,000 to Felten. A further example of an encapsulant composition to protect embedded resistors is found in US Patent Application No. 10/754,348 to Summers et al.

### SUMMARY OF THE INVENTION

Compositions are disclosed comprising: one or more epoxy containing cyclic olefin resin with a water absorption of 2% or less; one or more phenolic resins with water absorption of less than 2% or less; an epoxy catalyst; optionally one or more of an electrically insulated filler, a defoamer and a colorant, and one or more organic solvents. The compositions typically have a cure temperature of 190°C or less.

A fired-on-foil ceramic capacitor coated with an encapsulant of the disclosed composition and embedded in a printed wiring board or integrated circuit (IC) package structure is also disclosed, wherein said encapsulant provides protection to the capacitor from moisture and printed wiring board chemicals prior to and after embedding into the printed wiring board and said embedded capacitor structure passes 1000 hours of accelerated life testing conducted at 85°C, 85% relative humidity under 5 volts of DC bias.

Compositions are also disclosed comprising: one or more epoxy containing cyclic olefin resin with a water absorption of 2% or less; an epoxy catalyst; optionally one or more electrically insulated fillers, defoamers and colorants, and an organic solvent. The compositions typically have a cure temperature of 190°C or less.

The invention is also directed to a method of encapsulating a fired-on-foil ceramic capacitor comprising: one or more epoxy-containing cyclic olefin resin with a water absorption of 2% or less, one or more phenolic resins with water absorption of 2% or less, an epoxy catalyst, optionally one or more of an inorganic electrically insulating filler, a defoamer and a colorant, and one or more of an organic solvent to provide an uncured composition; applying the uncured composition to coat a fired-on-foil ceramic capacitor; and curing the applied composition at a temperature of equal to or less than 190°C.

The inventive compositions containing the organic materials can be applied as an encapsulant to any other electronic component or mixed with inorganic electrically insulating fillers, defoamers, and colorants, and applied as an encapsulant to any electronic component.

According to common practice, the various features of the drawings are not necessarily drawn to scale. Dimensions of various features may be expanded or reduced to more clearly illustrate the embodiments of the invention.

### BRIEF DESCRIPTION OF THE DRAWINGS

Figure 1A shows electrical materials screen printed on an alumina substrate to form a pattern.
Figure 1B shows a protrusion that allows connections at a later stage.
Figure 1C shows dielectric material screen printed onto electrode 130 to form a first dielectric layer. After the first dielectric layer is dried, a second dielectric layer is applied.
Figure 1D shows a plan view of the dielectric pattern.
Figure 1E shows copper paste printed over a second layer.
Figure 1F shows the pattern used in screen printing an encapsulant pattern through a mesh screen over the capacitor electrode and dielectric.
Figure 1G shows a side view of the final stack after the screen printing of the encapsulant layer.
Figures 2A-2G show a fired on foil capacitor made using the processes described on pages 28 and 29.
Figure 3A shows, in side elevation, a copper paste applied as a prreprint to copper foil, which is then fired.
Figure 3B shows a plan view of the preprint pattern.
Figure 3C shows dielectric layers applied to the preprint.
Figure 3D shows copper paste printed over a second dielectric layer.
Figure 3E shows a plan view of the capacitor on foil structure after a first dielectric, second dielectric and copper foil are applied to form the electrode.
Figure 3F shows a structure where a fired on foil capacitor side is laminated and a copper foil is applied to the laminate structure.
Figure 3G shows a view after lamination where a photo-resist is applied to the foil and the foil is imaged, etched and stripped.
Figure 3H is a plan view of a foil electrode design.
Figure 3I shows an inner panel incorporated inside a printed wiring board containing prepreg and copper foils.
Figure 3J Shows vias drilled and plated and outer copper layers etched and finished with nickel/gold plating.
Figure 4A -4D shows the steps in formation of a copper paste on copper foil electrode layer.
Figure 4E is a plan view of a capacitor on foil structure.
Figure 4F shows formation of an encapsulant layer in side elevation and 4G shows it in plan view.
Figure 4H shows a view after lamination with a prepreg and copper foil.
Figure 41 shows a view, after lamination, where a photo-resist is applied to the foil and the foil is imaged and etched.

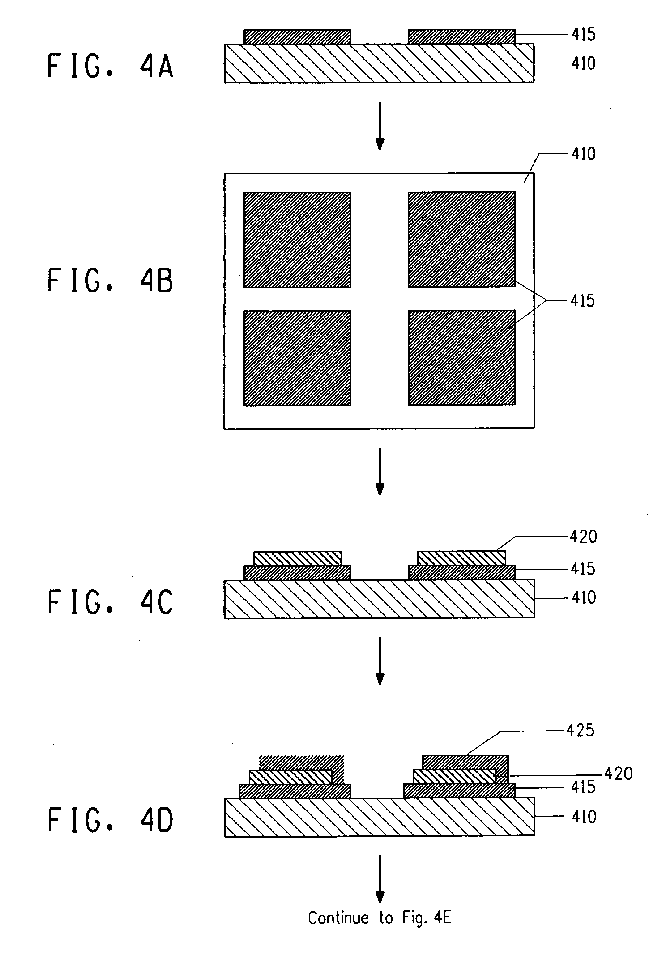

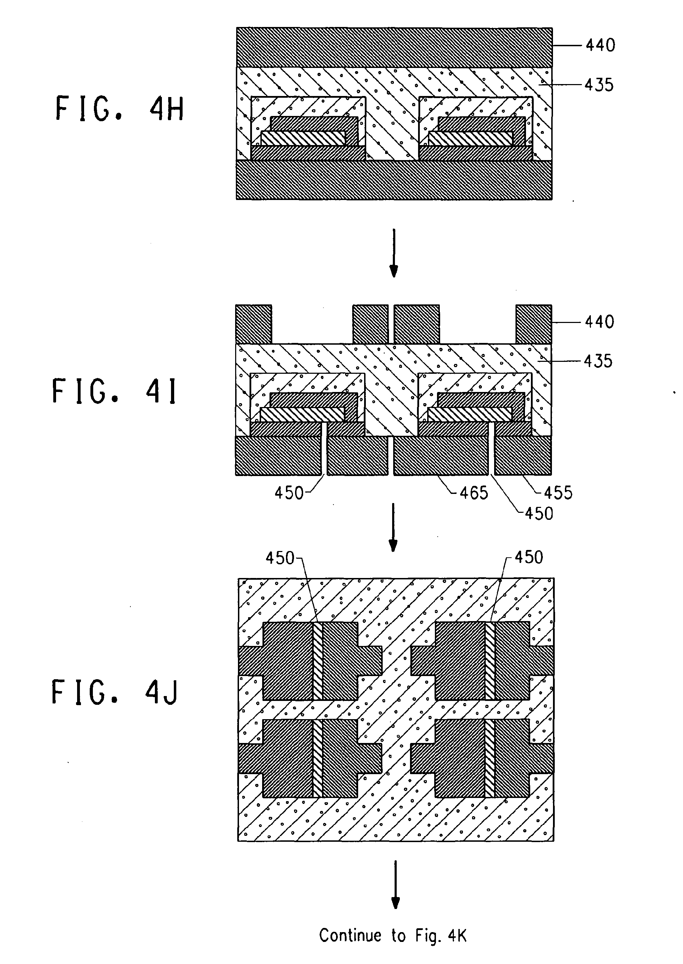

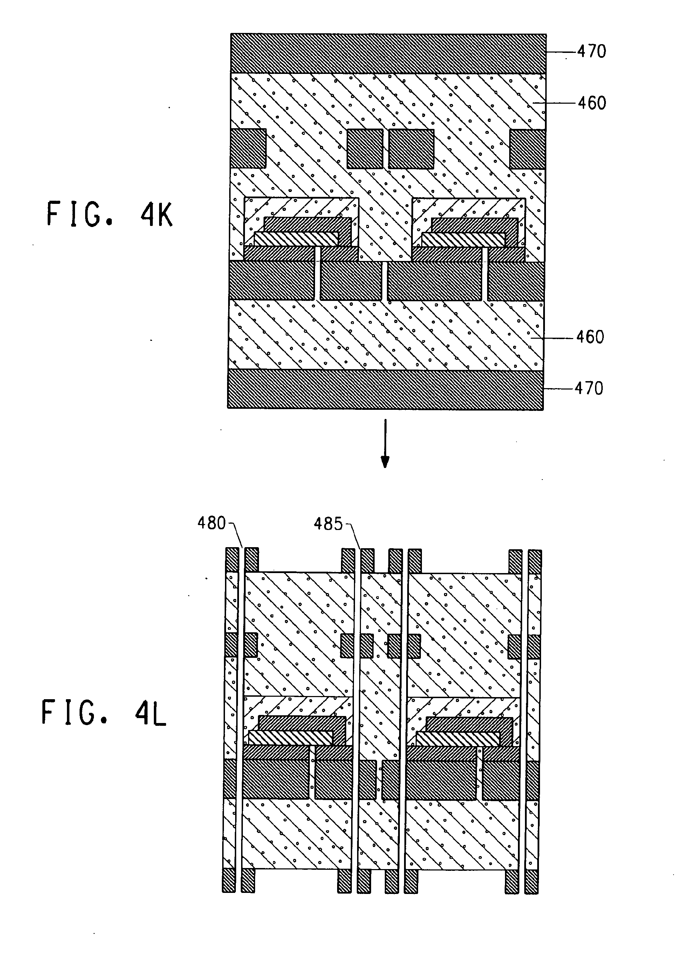

Figure 4J is a plan view of the electrodes formed from the foil containing the fired on capacitors.
Figure 4K shows an inner layer panel incorporated inside a printed wiring board by lamination with prepreg and copper foil.
Figure 4L shows vias drilled and plated and copper layers etched and finished to create surface terminals connected to the capacitor.

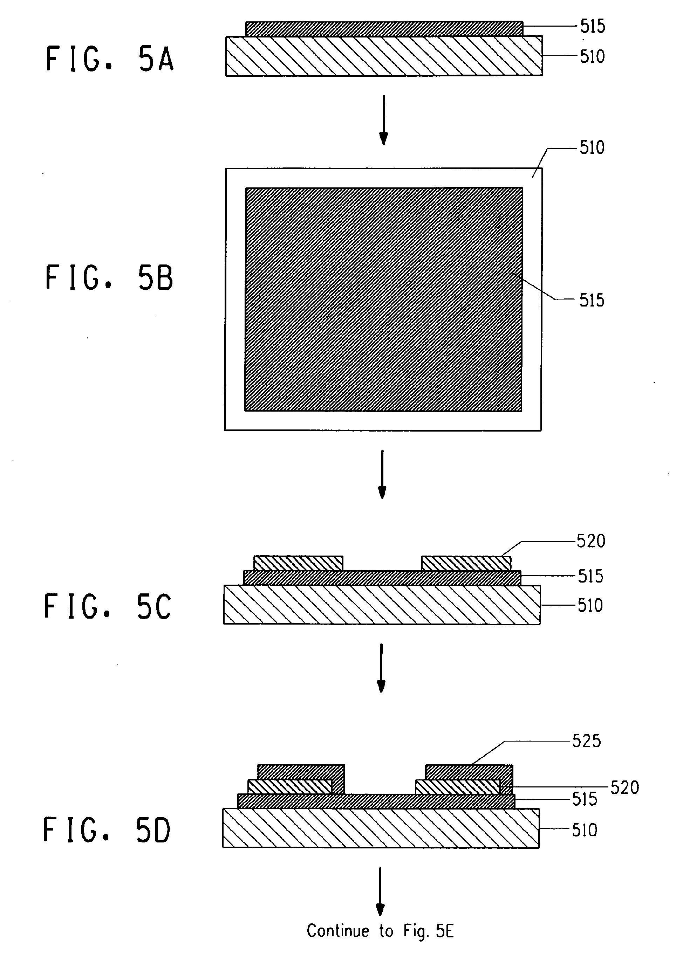

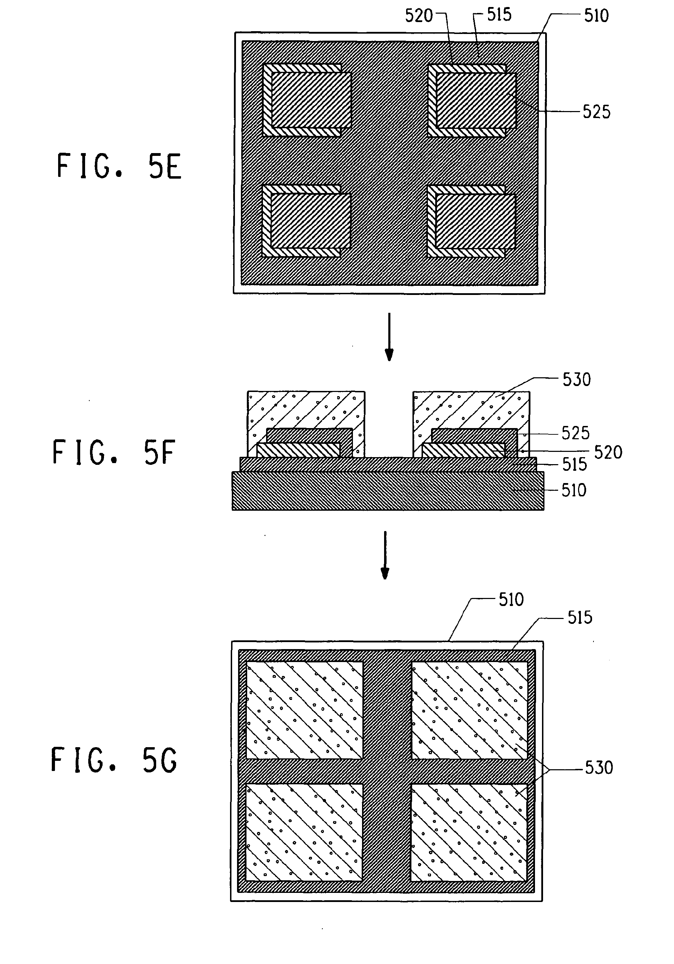

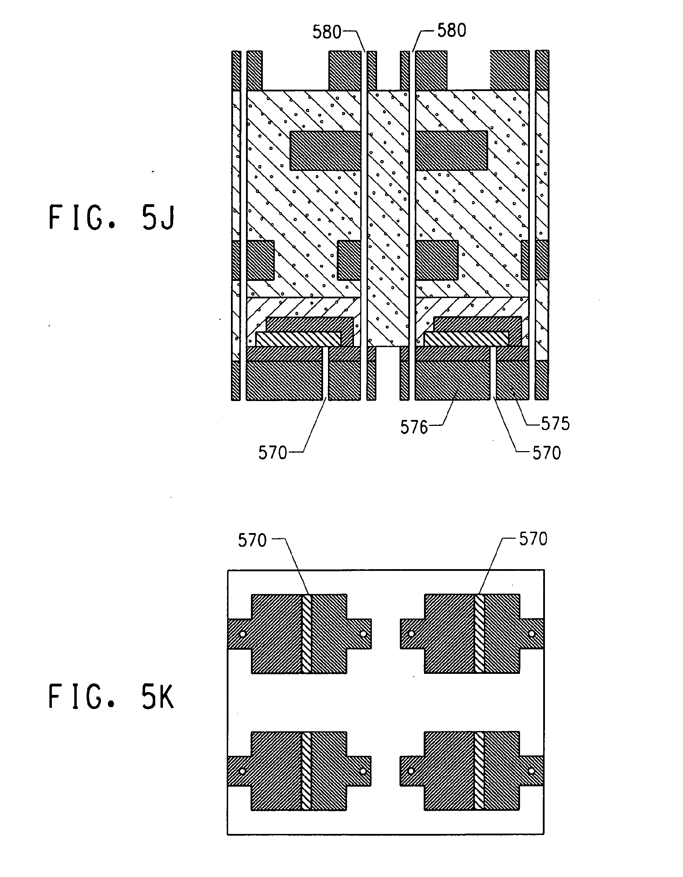

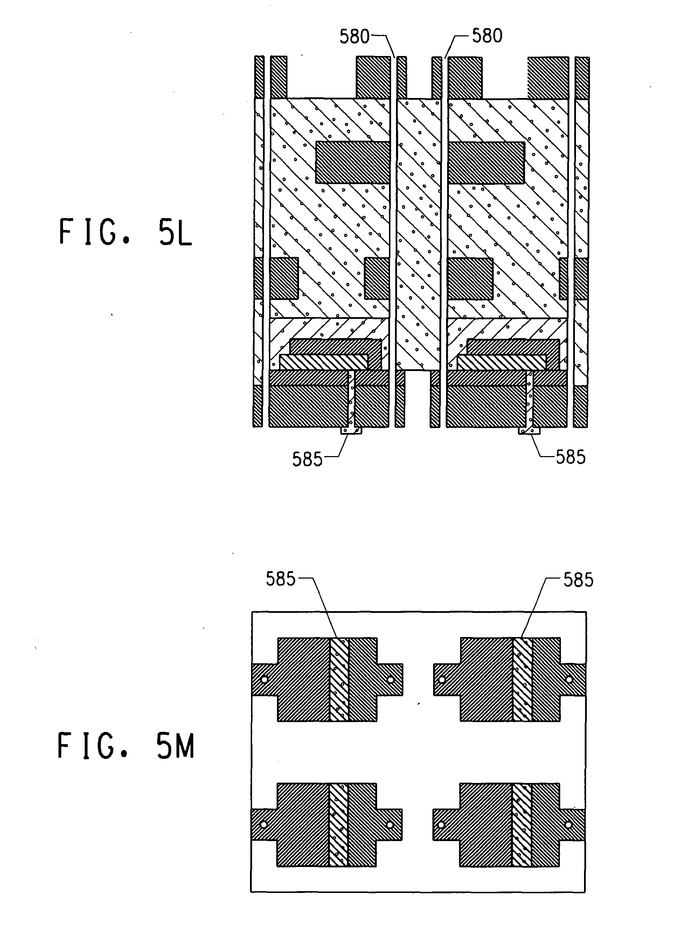

Figures 5A-5M describe a process for making printed wiring boards.

### DETAILED DESCRIPTION OF THE INVENTION

Compositions are disclosed comprising an epoxy-containing cyclic olefin resin with a water absorption of 2% or less, one or more phenolic resins with water absorption of 2% or less, an epoxy catalyst, an organic solvent, and optionally one or more of an inorganic electrically insulating filler, a defoamer and a colorant dye. The amount of water absorption is determined by ASTM D-570, which is a method known to those skilled in the art.

A fired-on-foil ceramic capacitor coated with an encapsulant and embedded in a printed wiring board is also disclosed. The application and processing of the encapsulant is designed to be compatible with printed wiring board and IC package processes and provides protection to the fired-on-foil capacitor from moisture and printed wiring board fabrication chemicals prior to and after embedding into the structure. Application of said encapsulant to the fired-on-foil ceramic capacitor allows the capacitor embedded inside the printed wiring board to pass 1000 hours of accelerated life testing conducted at 85°C, 85% relative humidity under 5 volts of DC bias.

Applicants determined that the most stable polymer matrix is achieved with the use of crosslinkable resins that also have low moisture absorption of 2% or less, preferably 1.5% or less, more preferably 1% or less. Polymers used in the compositions with water absorption of 1% or less tend to provide cured materials with preferred protection characteristics.

The use of the crosslinkable composition of the invention provides important performance advantages over the corresponding non-crosslinkable polymers. The ability of the polymer to crosslink with crosslinking agents during a thermal cure can stabilize the binder matrix, raise the Tg, increase chemical resistance, or increase thermal stability of the cured coating compositions.

The crosslinkable compositions will include polymers selected from the group consisting of epoxy-containing cyclic olefin resins particularly epoxy-modified polynorbornene (Epoxy-PNB), dicyclopentadiene epoxy resin and mixtures thereof. Preferably, the Epoxy-PNB resin, available from Promerus as Avatrel^{™}2390, or dicyclopentadiene epoxy resin used in the compositions will have water absorption of 1% or less.

The composition of the invention can include an Epoxy- PNB polymer comprising molecular units of formula I and II: 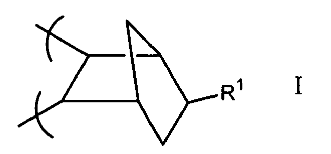 wherein R¹ is independently selected from hydrogen and a (C₁-C₁₀) alkyl. The term "alkyl" includes those alkyl groups with one to ten carbons of either a straight, branched or cyclic configuration. An exemplary list of alkyl groups include methyl, ethyl, propyl, isopropyl and butyl. Also typically included is a PNB polymer with crosslinkable sites as depicted by molecular units of formula II: 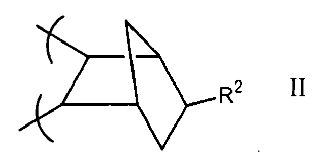 wherein R² is a pendant cross-linkable epoxy group and the molar ratio of molecular units of formula II to molecular units of formula I in the Epoxy-PNB polymer is greater than 0 and up to about 0.4, preferably greater than 0 up to about 0.2. The crosslinkable epoxy group in the PNB polymer provides a site at which the polymer can crosslink with one or more crosslinking agents in the compositions of the invention as the compositions are cured. Only a small amount of crosslinkable sites on the PNB polymer is needed to provide an improvement in the cured material. For example, the compositions may include Epoxy-PNB polymers with a mole ratio as defined above that is greater than 0 up to about 0.1.

Phenolic resins with water absorption of 2% or less are required to react with the epoxy to provide an effective moisture resistant material. An exemplary list of phenolic resins useful as thermal crosslinkers that can be used with the crosslinkable polymers include a dicyclopentadiene phenolic resin, and resins of cyclolefins condensed with phenolics. A suitable dicyclopentadiene phenolic resin, available from Borden as Durite® ESD-1819, is depicted as:

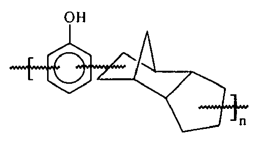

Applicants have also observed that the use of a crosslinkable Epoxy-PNB polymer in a composition can provide important performance advantages over the corresponding non-crosslinkable PNB polymers. The ability of the Epoxy-PNB polymer to crosslink with crosslinking agents during a thermal cure can stabilize the binder matrix, raise the Tg, increase chemical resistance, or increase thermal stability of the cured coating compositions.

The use of an epoxy catalyst that is not reactive at ambient temperatures is important to provide stability of the crosslinkable composition prior to being used. The catalyst provides catalytic activity for the epoxy reaction with the phenolic during the thermal cure. A catalyst that fulfills these requirements is dimethybenzylamine, and a latent catalyst that fulfills these requirements is dimethylbenzylammonium acetate, which is the reaction product of dimethylbenzylamine with acetic acid.

The compositions include an organic solvent. The choice of solvent or mixtures of solvents will depend in-part on the reactive resins used in the composition. Any chosen solvent or solvent mixtures must dissolve the resins and not be susceptible to separation when exposed to cold temperatures, for example. An exemplary list of solvents are selected from the group consisting of terpineol, ether alcohols, cyclic alcohols, ether acetates, ethers, acetates, cyclic lactones, and aromatic esters.

Most encapsulant compositions are typically applied to a substrate or component by screen printing a formulated composition, although stencil printing, dispensing, doctor blading into photoimaged or otherwise preformed patterns, or other techniques known to those skilled in the art are possible.

Thick-film encapsulant pastes must be formulated to have appropriate characteristics so that they can be printed readily. Thick-film encapsulant compositions, therefore, include an organic solvent suitable for screen printing and optional additions of defoaming agents, colorants and finely divided inorganic fillers as well as the resins. The defoamers help to remove entrapped air bubbles after the encapsulant is printed. Applicants determined that silicone containing organic defoamers are particularly suited for defoaming after printing. The finely divided inorganic fillers impart some measure of thixotropy to the paste, thereby improving the screen printing rheology. Applicants determined that fumed silica is particularly suited for this purpose. Colorants may also be added to improve automated registration capability. Such colorants may be organic dye compositions, for example. The composition may also comprise a photopolymer for photodefining the encapsulant for use with very fine features. The organic solvent should provide appropriate wettability of the solids and the substrate, have sufficiently high boiling point to provide long screen life and a good drying rate. The organic solvent along with the polymer also serves to disperse the finely divided insoluble inorganic fillers with an adequate degree of stability. Applicants determined that terpineol is particularly suited for the screen printable paste compositions of the invention.

Generally, thick-film compositions are mixed and then blended on a three-roll mill. Pastes are typically roll-milled for three or more passes at increasing levels of pressure until a suitable dispersion has been reached. After roll milling, the pastes may be formulated to printing viscosity requirements by addition of solvent.

Curing of the paste or liquid composition is accomplished by any number of standard curing methods including convection heating, forced air convection heating, vapor phase condensation heating, conduction heating, infrared heating, induction heating, or other techniques known to those skilled in the art.

One advantage that the polymers provide to the compositions of the invention is a relatively low cure temperature. The compositions may be cured with a temperature of equal to or less than 190°C over a reasonable time period. This is particularly advantageous as it is compatible with printing wiring board processes and avoids oxidation of copper foil or damage or degradation to component properties.

It is to be understood, that the 190°C temperature is not a maximum temperature that may be reached in a curing profile. For example, the compositions may also be cured using a peak temperature up to about 270°C with a short infrared cure. The term "short infrared cure" is defined as providing a curing profile with a high temperature spike over a period that ranges from a few seconds to a few minutes.

Another advantage that the polymers provide to the compositions of the inventions is a relatively high adhesion to prepreg when bonded to the prepreg using printed wiring board or IC package substrate lamination processes. This allows for reliable lamination processes and sufficient adhesion to prevent de-lamination in subsequent processes or use.

The encapsulant paste compositions of the invention may further include one or more metal adhesion agents. Preferred metal adhesion agents are selected from the group consisting of polyhydroxyphenylether, polybenzimidazole, polyetherimide, polyamideimide and 2-mercaptobenzimidazole (2-MB).

The compositions of the invention may also be provided in a solution and used in IC and wafer-level packaging as semiconductor stress buffers, interconnect dielectrics, protective overcoats (e.g., scratch protection, passivation, etch mask, etc.), bond pad redistribution, and solder bump underfills. One advantage provided by the compositions is the low curing temperature typically of less than 190°C or short duration at a peak temperature of 270°C with short IR cure. Current packaging requires a cure temperature of about 300°C+/- 25°C.

As noted the composition(s) of the present invention are useful in many applications. The composition(s) may be used as protection for any electronic, electrical or non-electrical component. For example, the composition(s) may be useful in integrated circuit packages, wafer-level packages and hybrid circuit applications in the areas of semiconductor junction coatings, semiconductor stress buffers, interconnect dielectrics, protective overcoats for bond pad redistribution, "glob top" protective encapsulation of semiconductors, or solder bump underfills. Furthermore, the compositions may be useful in battery automotive ignition coils, capacitors, filters, modules, potentiometers, pressure sensitive devices, reisistors, switches, sensors, transformers, voltage regulators, lighting applications such as LED coatings for LED chip carriers and modules, sealing and joining medical and implantable devices, and solar cell coatings.

Test procedures used in the testing of the compositions of the invention and for the comparative examples are provided as follows:

### Insulation Resistance

Insulation resistance of the capacitors is measured using a Hewlett Packard high resistance meter.

### Temperature Humidity Bias (THB) Test

THB Test of ceramic capacitors embedded in printed wiring boards involves placing the printed wiring board in an environmental chamber and exposing the capacitors to 85°C, 85% relative humidity and a 5 volt DC bias. Insulation resistance of the capacitors is monitored every 24 hours. Failure of the capacitor is defined as a capacitor showing less than 50 mega-ohms in insulation resistance.

### Brown Oxide Test

The device under test is exposed to an Atotech brown oxide treatment with a series of steps: (1) 60 sec. soak in a solution of 4-8% H₂SO₄ at 40°C, (2) 120 sec. soak in soft water at room temperature, (3) 240 sec soak in a solution of 3-4% NaOH with 5-10% amine at 60°C, (4)120 sec. soak in soft water at room temperature, (5) 120 sec. soak in 20 ml/l H₂O₂ and H₂SO₄ base with additive at 40°C, (6) a soak for 120 sec. in a solution of Part A 280, Part B 40 ml/l at 40°C, and (7) a deionized water soak for 480 sec. at room temperature.

Insulation resistance of the capacitor is then measured after the test and failure is defined as a capacitor showing less than 50 Mega-Ohms.

### Black Oxide Test

Black oxide processes are similar nature and scope to the brown oxide procedures described above, however the acid and base solutions in a traditional black oxide process can possess concentrations as high as 30%. Thus, the reliability of encapsulated dielectrics was evaluated after exposure to 30% sulfuric acid and 30% caustic solutions, 2 minute and 5 minute exposure times respectively.

### Corrosion Resistance Test

Samples of the encapsulant are coated on copper foil and the cured samples are placed in a fixture that contacts the encapsulant coated side of the copper foil to 3% NaCl solution in water that is heated to 60°C. A 2V and 3V DC bias is applied respectively during this test. The corrosion resistance (Rp) is monitored periodically during a 10-hour test time.

### Water Permeation Test

Samples of the encapsulant are coated on copper foil and the cured samples are placed in a fixture that contacts the encapsulant coated side of the copper foil to 3% NaCl solution in water that is heated to 60°C. No bias is applied during this test. The water permeation rate indicated by a capacitance increase was monitored periodically during a 10-hour test time.

The following glossary contains a list of names and abbreviations for each ingredient used:

| | |
|---|---|
| PNB | Polynorbornene Appear-3000B from Promerus LLC of Brecksville, Ohio;Tg 330°C, 0.03% moisture absorption |
| Epoxy-PNB | Epoxy-containing polynorbornene from Promerus LLC of Brecksville, Ohio; Mw of 74,000, Mn of 30,100 |
| Durite ESD-1819 | Dicyclopentadiene phenolic resin from Borden Chemical, Inc. of Louisville, Kentucky. |
| Fumed silica | High surface area silica obtainable from several sources, such as Degussa. |
| Organosiloxane antifoam agent | Defoaming agent SWS-203 obtainable from Wacker Silicones Corp. |

### EXAMPLES

### Example 1

An encapsulant composition was prepared according to the following composition and procedure:

| Material | Weight % |
|---|---|
| Epoxy-PNB pre-dissolved in dibutyl carbitol at 50.0% solids | 23.37 |
| ESD-1819 pre-dissolved in dibutyl carbitol at 50.0% solids | 23.37 |
| N,N-dimethylbenzylammonium acetate | 0.47 |
| Titanium dioxide powder | 31.67 |
| Alumina powder | 21.12 |

The mixture was roll milled with a 1-mil (25.4 µm) gap with 3 passes each at 0, 50, 100, 200, 250 and 300 psi (3.4 x 10⁵, 6.9 x 10⁵, 1.38 x 10⁶ and 2.07 x 10⁶ Pa) to yield well dispersed paste.

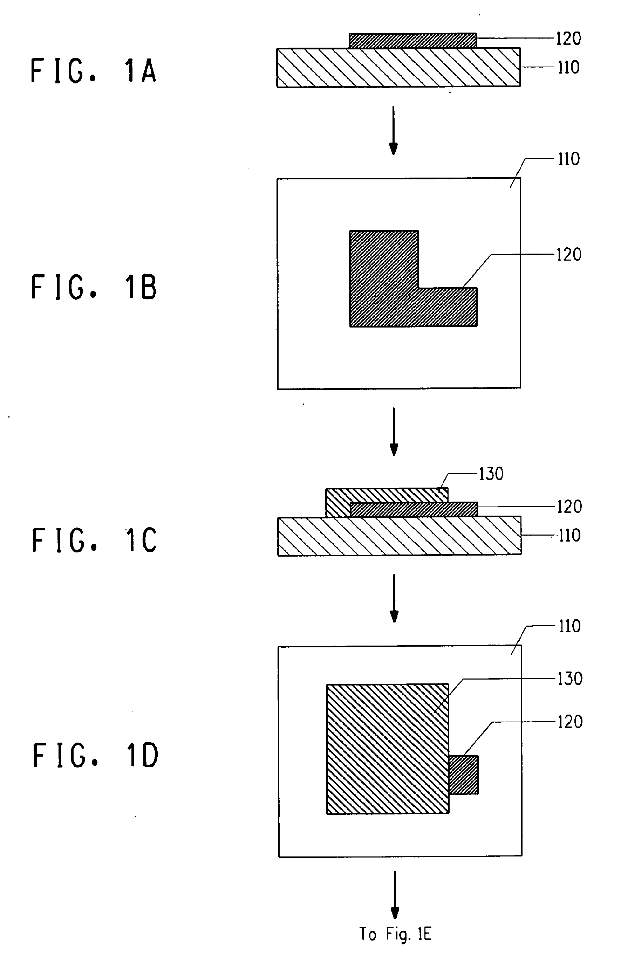

Capacitors on commercial 96% alumina substrates were covered by encapsulant compositions and used as a test vehicle to determine the encapsulant's resistance to selected chemicals. The test vehicle was prepared in the following manner as schematically illustrated in FIG. 1A through 1 G:

As shown in FIG. 1A, electrode material (EP 320 obtainable from DuPont Electronics) was screen-printed onto the alumina substrate to form electrode pattern **120.** As shown in FIG. 1B, the area of the electrode was 0.3 inch by 0.3 inch (0.76 cm by 0.76 cm) and contained a protruding "finger" to allow connections to the electrode at a later stage. The electrode pattern was dried at 120°C for 10 minutes and fired at 930°C under copper thick-film nitrogen atmosphere firing conditions.

As shown in FIG. 1C, dielectric material (EP 310 obtainable from DuPont Electronics) was screen-printed onto the electrode to form dielectric layer **130.** The area of the dielectric layer was approximately 0.33 inch by 0.33 inch (0.84 cm by 0.84 cm) and covered the entirety of the electrode except for the protruding finger. The first dielectric layer was dried at 120°C for 10 minutes. A second dielectric layer was then applied, and also dried using the same conditions. A plan view of the dielectric pattern is shown in FIG. 1 D.

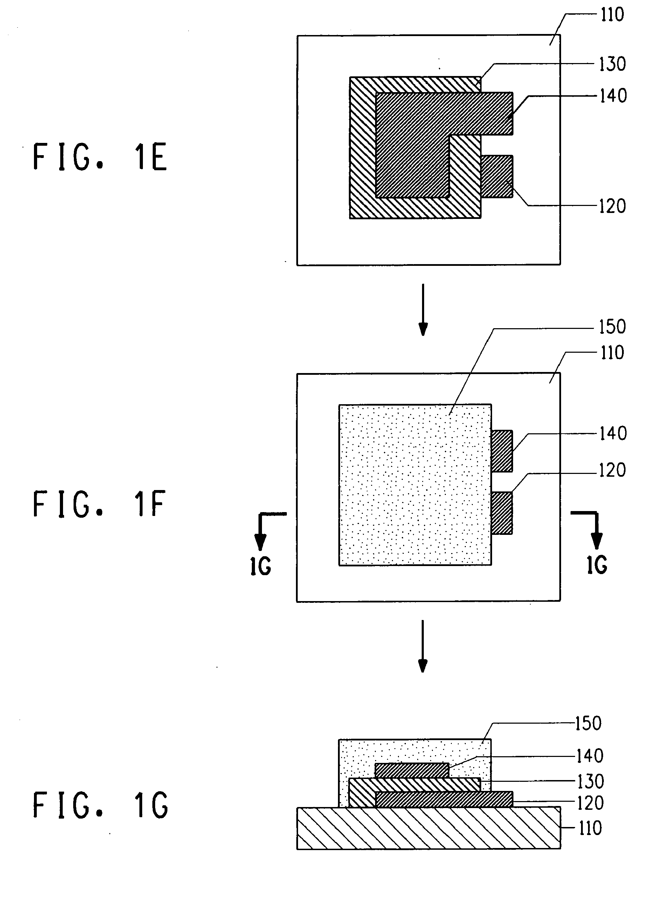

As shown in FIG. 1 E, copper paste EP 320 was printed over the second dielectric layer to form electrode pattern **140.** The electrode was 0.3 inch by 0.3 inch (0.76 cm by 0.76 cm) but included a protruding finger that extended over the alumina substrate. The copper paste was dried at 120°C for 10 minutes.

The first dielectric layer, the second dielectric layer, and the copper paste electrode were then co-fired at 930°C under copper thick-film firing conditions.

The encapsulant composition was screen printed through a 400 mesh screen over the entirety of the capacitor electrode and dielectric except for the two fingers using the pattern shown in FIG. 1 F to form a 0.4 inch by 0.4 inch (1.02 cm by 1.02 cm) encapsulant layer **150**. The encapsulant layer was dried for 10 minutes at 120°C. Another layer of encapsulant was printed and dried for 10 minutes at 120°C. A side view of the final stack is shown in FIG. 1G. The two layers of encapsulant were then baked under nitrogen in a forced draft oven at 170°C for 1 hr followed by a ramp up to 230°C and held for 5 minutes. The final cured thickness of the encapsulant was approximately 10 µm.

In a water permeation test, the encapsulant film capacitance remained unchanged during an immersion time of > 450 minutes. In a corrosion resistance test, the corrosion resistance (Rₚ) remained unchanged after an immersion time of 9 hours. The adhesion of the encapsulant was measured to be 2.2 pounds/inch (0.39 kg/cm) over the copper electrode and 3.0 pounds/inch (0.54 kg/cm) over the capacitor dielectric.

### Example 2

An encapsulant composition was prepared using the following ingredients and processes:

| Ingredients: | Preparation of Epoxy Medium |
|---|---|
| Terpineol | 300g |
| Avatrel 2390 epoxy resin (AV2390) | 200g |

A 1 liter resin kettle was fitted with a heating jacket, mechanical stirrer, nitrogen purge, thermometer, and addition port. The terpineol was added to the kettle and heated to 40°C. After the terpineol reached 40°C, the epoxy was added through the addition port to the stirring solvent. After complete addition, the powder gradually dissolved to yield a clear and colorless solution of moderate viscosity. Complete dissolution of the polymer took approximately two hours. The medium was then cooled to room temperature and discharged from the reactor. The solid content of the finished medium was analyzed by heating a known quantity of medium for two hours at 150°C. The solids content was determined to be 40.33% by this method. The viscosity of the medium was also determined to be 53.2 Pa.S. at 10 rpm using a Brookfield Viscometer 2HA, utility cup and number 14 spindle.

| Ingredients: | Preparation of Phenolic Medium |
|---|---|
| Terpineol | 300g |
| Durite ESD-1819 phenolic resin (ESD1819) | 200g |

A resin kettle was fitted with a heating mantle, mechanical stirrer, nitrogen purge, thermometer, and addition port. The terpineol was added to the kettle and preheated to 80°C. The phenolic resin was crushed with a morter and pestle, then added to the terpineol with stirring. After complete addition, the powder gradually dissolved to yield a dark red solution of moderate viscosity. Complete dissolution of the polymer took approximately one hour. The medium was then cooled to room temperature and discharged from the reactor. The solid content of the finished medium was analyzed by heating a known quantity of medium for two hours at 150°C. The solids content was determined to be 40.74% by this method. The viscosity of the medium was also determined to be 53.6 Pa.S. at 10 rpm using a Brookfield Viscometer 2HA, utility cup and number 14 spindle.

Preparation of an encapsulant paste containing 16% Degussa R7200 fumed silica:

| Ingredients: | |
|---|---|
| Epoxy medium | 12.4g |
| Phenolic medium | 12.4g |
| Degussa R7200 fumed silica | 5.0g |
| Terpineol | 2.4g |
| Organosiloxane antifoam agent | 0.2g |
| Benzyldimethylammonium acetate | 0.1g |

The epoxy medium, phenolic medium, organosiloxane, and catalyst were combined in a suitable container and hand-stirred for approximately 5 minutes to homogenize the ingredients. The silica was then added in three equal aliquots with hand stirring followed by vacuum mixing at low agitation between each addition. After complete addition of the silica, the crude paste was vacuum mixed for 15 minutes with medium agitation. After mixing, the paste was three roll milled according to the following schedule:

| Pass | Feed roll pressure (psi (Pa)) | Apron roll pressure (psi (Pa)) |
|---|---|---|
| 1 | 0 | 0 |
| 2 | 0 | 0 |
| 3 | 100 (6.9x10⁵ Pa) | 100 (6.9x10⁵ Pa) |
| 4 | 200 (1.38x10⁶ Pa) | 100 (6.9x10⁵ Pa) |
| 5 | 300 (2.07x10⁶ Pa) | 200 (1.38x10⁶ Pa) |
| 6 | 400 (2.76x10⁶ Pa) | 300 (2.07x10⁶ Pa) |

Terpineol was then added to the finished paste with stirring to modify the paste viscosity and make it suitable for screen printing.

The encapsulant composition was screen printed through a 400 mesh screen over the capacitor electrode and dielectric using the pattern **150** shown in FIG. 1F. It was dried for 10 minutes at 120°C. Another layer of encapsulant was printed and dried for 60 minutes at 120°C. The two layers of encapsulant were then cured in air at 170°C for 90 minutes followed by a short "spike" cure of 15 minutes at 200°C in air. The final cured thickness of the encapsulant was approximately 10 µm.

After encapsulation, the average capacitance of the capacitors was 42.5 nF, the average loss factor was 1.5%, the average insulation resistance was 1.2 Gohms. The coupons were then dipped in a 5% sulfuric acid solution at room temperature for 6 minutes, rinsed with deionized water, then dried at 120°C for 30 minutes. The average capacitance, loss factor, and insulation resistance were 42.8 nF, 1.5%, 1.1 Gohms respectively after the acid treatment.

Three inch squares of the encapsulant paste were also printed and cured on 6" square one oz. (28.3 g) copper sheets to yield defect-free coatings suitable for corrosion resistance testing as described above. The coatings were exposed for 12 hours to a 3% NaCl solution under 2V and 3V DC bias. The corrosion resistance remained above 7x10⁹ ohms.cm² at 0.01 Hz, during the test.

### Example 3

An encapsulant was prepared with the same composition as described in example 2 except the Degussa R7200 fumed silica was substituted by Cabot Cab-O-Sil TS-530 fumed silica. The encapsulant was prepared according to the procedure outlined in Example 2.

The encapsulant was printed and cured over the capacitors prepared on alumina substrates as described in Example 2. After encapsulation, the average capacitance of the capacitors was 39.2 nF, the average loss factor was 1.5%, the average insulation resistance was 2.3 Gohms. The coupons were then dipped in a 5% sulfuric acid solution at room temperature for 6 minutes, rinsed with deionized water, then dried at 120°C for 30 minutes. The average capacitance, loss factor, and insulation resistance were 42.3 nF, 1.5%, 2.6 Gohms respectively after the acid treatment.

### Example 4

An encapsulant was prepared with the same composition as described in example 2 except the Degussa R7200 fumed silica was substituted by Cabot CAB-OHS-5 fumed silica. The encapsulant was prepared according to the procedure outlined in Example 2.

The encapsulant was printed and cured over the capacitors prepared on alumina substrates as described in Example 2. After encapsulation, the average capacitance of the capacitors was 39.9 nF, the average loss factor was 1.6%, the average insulation resistance was 3.1 Gohms. The coupons were then dipped in a 5% sulfuric acid solution at room temperature for 6 minutes, rinsed with deionized water, then dried at 120°C for 30 minutes. The average capacitance, loss factor, and insulation resistance were 40.3 nF, 1.6%, 2.8 Gohms respectively after the acid treatment.

### Example 5

An encapsulant was prepared with the same composition as described in example 2 except the Degussa R7200 fumed silica was substituted by Cabot Cab-O-Sil TS-500 fumed silica. The encapsulant was prepared according to the procedure outlined in Example 2.

The encapsulant was printed and cured over the capacitors prepared on alumina substrates as described in Example 2. After encapsulation, the average capacitance of the capacitors was 40.2 nF, the average loss factor was 1.5%, the average insulation resistance was 2.2 Gohms. The coupons were then dipped in a 5% sulfuric acid solution at room temperature for 6 minutes, rinsed with deionized water, then dried at 120°C for 30 minutes. The average capacitance, loss factor, and insulation resistance were 41.8 nF, 1.5%, 2.4 Gohms respectively after the acid treatment.

### Example 6

An encapsulant with the following composition containing 13% by weight Degussa R7200 fumed silica was prepared according to the procedure outlined in Example 2:

| | |
|---|---|
| Epoxy medium | 40g |
| Phenolic medium | 14.2g |
| Degussa R7200 fumed silica | 8.1 g |
| Terpineol | 2.4g |
| Organosiloxane antifoam agent | 0.31g |
| Benzyldimethylammonium acetate | 0.15g |

The encapsulant was printed and cured over the capacitors prepared on alumina substrates as described in Example 2. After encapsulation, the average capacitance of the capacitors was 40.4 nF, the average loss factor was 1.5%, the average insulation resistance was 3.2 Gohms. The coupons were then dipped in a 5% sulfuric acid solution at room temperature for 6 minutes, rinsed with deionized water, then dried at 120°C for 30 minutes. The average capacitance, loss factor, and insulation resistance were 40.8 nF, 1.5%, 2.9 Gohms respectively after the acid treatment.

### Example 7

An encapsulant with the following composition containing 8% by weight Degussa R7200 fumed silica was prepared according to the procedure outlined in Example 2

| | |
|---|---|
| Epoxy medium | 12.4g |
| Phenolic medium | 12.4g |
| Degussa R7200 fumed silica | 2.4g |
| Organosiloxane antifoam agent | 0.2g |
| Benzyldimethylammonium acetate | 0.12g |

The encapsulant was printed and cured over the capacitors prepared on alumina substrates as described in Example 2. After encapsulation, the average capacitance of the capacitors was 35.1 nF, the average loss factor was 1.5%, the average insulation resistance was 2.0 Gohms. The coupons were then dipped in a 30% sulfuric acid solution at 45°C for 2 minutes, rinsed with deionized water, then dried at 120°C for 30 minutes. The average capacitance, loss factor, and insulation resistance were 35.7nF, 1.6%, 2.0 Gohms respectively after the acid treatment.

### Example 8

An encapsulant was prepared with the same composition as described in example 7 except the Degussa R7200 fumed silica was substituted by Cabot Cab-O-Sil TS-530 fumed silica. The encapsulant was prepared according to the procedure outlined in Example 2.

The encapsulant was printed and cured over the capacitors prepared on alumina substrates as described in Example 2. After encapsulation, the average capacitance of the discrete dielectrics was 35.5 nF, the average loss factor was 1.5%, the average insulation resistance was 3.0 Gohms. The coupons were then dipped in a 30% sulfuric acid solution at 45°C for 2 minutes, rinsed with deionized water, then dried at 120°C for 30 minutes. The average capacitance, loss factor, and insulation resistance were 36.3 nF, 1.6%, 1.9 Gohm respectively after the acid treatment.

### Example 9

An encapsulant was prepared with the same composition as described in example 7 except the Degussa R7200 fumed silica was substituted by Cabot CAB-OHS-5 fumed silica. The encapsulant was prepared according to the procedure outlined in Example 2.

The encapsulant was printed and cured over the capacitors prepared on alumina substrates as described in Example 2. After encapsulation, the average capacitance of the discrete dielectrics was 35.5 nF, the average loss factor was 1.4%, the average insulation resistance was 3.6 Gohms. The coupons were then dipped in a 30% sulfuric acid solution at 45°C for 2 minutes, rinsed with deionized water, then dried at 120°C for 30 minutes. The average capacitance, loss factor, and insulation resistance were 36.3 nF, 1.5%, 2.4 Gohms respectively after the acid treatment.

Three inch squares of the encapsulant paste were also printed and cured on 6" square one oz. (28.3 g) copper sheets to yield defect-free coatings suitable for corrosion resistance testing as described above. The coatings were exposed for 12 hours to a 3% NaCl solution under 2V and 3V DC bias. The corrosion resistance remained above 7x10⁹ ohms.cm² at 0.01 Hz, during the test.

### Example 10

An encapsulant was prepared with the same composition as described in example 7 except the Degussa R7200 fumed silica was substituted by Cabot Cab-O-Sil TS-500 fumed silica. The encapsulant was prepared according to the procedure outlined in Example 2.

The encapsulant was printed and cured over the capacitors prepared on alumina substrates as described in Example 2. After encapsulation, the average capacitance of the discrete dielectrics was 33 nF, the average loss factor was 1.4%, the average insulation resistance was 3.3 Gohms. The coupons were then dipped in a 30% sulfuric acid solution at 45°C for 2 minutes, rinsed with deionized water, then dried at 120°C for 30 minutes. The average capacitance, loss factor, and insulation resistance were 33.8 nF, 1.5%, 2.2 Gohm respectively after the acid treatment.

### Example 11

An encapsulant with the following composition containing 8% by weight Degussa R7200 fumed silica was prepared according to the procedure outlined in Example 2.

| | |
|---|---|
| Epoxy medium | 40.0g |
| Phenolic medium | 14.2g |
| Degussa R7200 fumed silica | 4.9g |
| Organosiloxane antifoam agent | 0.36g |
| Benzyldimethylammonium acetate | 0.13g |

The encapsulant was printed and cured over the capacitors prepared on alumina substrates as described in Example 2. To evaluate the encapsulant stability in the presence of strong acids and bases, selected coupons were then dipped in a 30% sulfuric acid solution at 45°C for 2 minutes, rinsed with deionized water, then dried at 120°C for 30 minutes. Additional coupons were exposed to a 30% sodium hydroxide bath at 60°C for 5 minutes. After exposure, these coupons were also rinsed with deionized water and dried prior to testing. The table below summarizes capacitor properties before and after acid and base exposure.

| **Condition** | **Capacitance (nF)** | **Dissipation factor (%)** | **Insulation Resistance (Gohm)** |
|---|---|---|---|
| After encapsulation | 33.5 | 1.4 | 4.4 |
| After base treatment | 34.9 | 1.5 | 5.1 |
| After acid treatment | 34.0 | 1.4 | 2.7 |

### Example 12

An encapsulant was prepared with the same composition as described in example 11 except the Degussa R7200 fumed silica was substituted by Cabot Cab-O-Sil TS-530 fumed silica. The encapsulant was prepared according to the procedure outlined in Example 2.

The encapsulant was printed and cured over the capacitors prepared on alumina substrates as described in Example 2. To evaluate the encapsulant stability in the presence of strong acids and bases, selected coupons were then dipped in a 30% sulfuric acid solution at 45°C for 2 minutes, rinsed with deionized water, then dried at 120°C for 30 minutes. Additional coupons were exposed to a 30% sodium hydroxide bath at 60°C for 5 minutes. After exposure, these coupons were also rinsed with deionized water and dried prior to testing. The table below summarizes capacitor properties before and after acid and base exposure.

| **Condition** | **Capacitance (nF)** | **Dissipation Factor (%)** | **Insulation Resistance (Gohm)** |
|---|---|---|---|
| After encapsulation | 43.6 | 1.4 | 2.0 |
| After base treatment | 44.4 | 1.4 | 1.9 |
| After acid treatment | 44.1 | 1.4 | 3.3 |

### Example 13

An encapsulant was prepared with the same composition as described in example 11 except the Degussa R7200 fumed silica was substituted by Cabot CAB-OHS-5 fumed silica. The encapsulant was prepared according to the procedure outlined in Example 2.

The encapsulant was printed and cured over the capacitors prepared on alumina substrates as described in Example 2. To evaluate the encapsulant stability in the presence of strong acids and bases, selected coupons were then dipped in a 30% sulfuric acid solution at 45°C for 2 minutes, rinsed with deionized water, then dried at 120°C for 30 minutes. Additional coupons were exposed to a 30% sodium hydroxide bath at 60°C for 5 minutes. After exposure, these coupons were also rinsed with deionized water and dried prior to testing. The table below summarizes capacitor properties before and after acid and base exposure.

Three inch squares of the encapsulant paste were also printed and cured on 6" square one oz. (28.3 g) copper sheets to yield defect-free coatings suitable for corrosion resistance testing as described above. The coatings were exposed for 12 hours to a 3% NaCl solution under 2V and 3V DC bias. The corrosion resistance remained above 7x10⁹ ohms.cm² at 0.01 Hz, during the test.

| **Condition** | **Capacitance (nF)** | **Dissipation Factor (%)** | **Insulation Resistance (Gohm)** |
|---|---|---|---|
| After encapsulation | 34.2 | 1.5 | 5.2 |
| After base treatment | 34.5 | 1.6 | 2.6 |
| After acid treatment | 35.4 | 1.5 | 3.7 |

### Example 14

An encapsulant was prepared with the same composition as described in example 11 except the Degussa R7200 fumed silica was substituted by Cabot Cab-O-Sil TS-500 fumed silica. The encapsulant was prepared according to the procedure outlined in Example 2.

The encapsulant was printed and cured over the capacitors prepared on alumina substrates as described in Example 2. To evaluate the encapsulant stability in the presence of strong acids and bases, selected coupons were then dipped in a 30% sulfuric acid solution at 45°C for 2 minutes, rinsed with deionized water, then dried at 120°C for 30 minutes. Additional coupons were exposed to a 30% sodium hydroxide bath at 60°C for 5 minutes. After exposure, these coupons were also rinsed with deionized water and dried prior to testing. The table below summarizes capacitor properties before and after acid and base exposure.

Three inch squares of the encapsulant paste were also printed and cured on 6" square one oz. (28.3 g) copper sheets to yield defect-free coatings suitable for corrosion resistance testing as described above. The coatings were exposed for 12 hours to a 3% NaCl solution under 2V and 3V DC bias. The corrosion resistance remained above 7x10⁹ ohms.cm² at 0.01 Hz, during the test.

| **Condition** | **Capacitance (nF)** | **Dissipation Factor (%)** | **Insulation Resistance (Gohm)** |
|---|---|---|---|
| After encapsulation | 37.3 | 1.4 | 3.6 |
| After base treatment | 36.8 | 1.4 | 3.8 |
| After acid treatment | 43.0 | 1.4 | 2.4 |

### Example 15

An encapsulant with the following composition containing 2% by weight Degussa R7200 fumed silica was prepared according to the procedure outlined in Example 2:

| | |
|---|---|
| Epoxy medium | 40.0g |
| Phenolic medium | 14.2g |
| Degussa R7200 fumed silica | 1.2g |
| Organosiloxane antifoam agent | 0.36g |
| Benzyldimethylammonium acetate | 0.13g |

The encapsulant was printed and cured over the capacitors prepared on alumina substrates as described in Example 2. To evaluate the encapsulant stability in the presence of strong acids and bases, selected coupons were then dipped in a 30% sulfuric acid solution at 45°C for 2 minutes, rinsed with deionized water, then dried at 120°C for 30 minutes. Additional coupons were exposed to a 30% sodium hydroxide bath at 60°C for 5 minutes. After exposure, these coupons were also rinsed with deionized water and dried prior to testing. The table below summarizes capacitor properties before and after acid and base exposure.

| **Condition** | **Capacitance (nF)** | **Dissipation Factor (%)** | **Insulation Resistance (Gohm)** |
|---|---|---|---|
| After encapsulation | 42.3 | 1.4 | 3.2 |
| After base treatment | 42.6 | 1.4 | 3.6 |
| After acid treatment | 43.6 | 1.4 | 2.5 |

### Example 16

An encapsulant was prepared with the same composition as described in example 15 except the Degussa R7200 fumed silica was substituted by Cabot Cab-O-Sil TS-530 fumed silica. The encapsulant was prepared according to the procedure outlined in Example 2.

The encapsulant was printed and cured over the capacitors prepared on alumina substrates as described in Example 2. To evaluate the encapsulant stability in the presence of strong acids and bases, selected coupons were then dipped in a 30% sulfuric acid solution at 45°C for 2 minutes, rinsed with deionized water, then dried at 120°C for 30 minutes. Additional coupons were exposed to a 30% sodium hydroxide bath at 60°C for 5 minutes. After exposure, these coupons were also rinsed with deionized water and dried prior to testing. The table below summarizes capacitor properties before and after acid and base exposure.

| **Condition** | **Capacitance (nF)** | **Dissipation Factor (%)** | **Insulation Resistance (Gohm)** |
|---|---|---|---|
| After encapsulation | 42.6 | 1.5 | 3.4 |
| After base treatment | 42.7 | 1.5 | 5.3 |
| After acid treatment | 41.6 | 1.5 | 3.1 |

### Example 17

An encapsulant was prepared with the same composition as described in example 15 except the Degussa R7200 fumed silica was substituted by Cabot CAB-OHS-5 fumed silica. The encapsulant was prepared according to the procedure outlined in Example 2.

The encapsulant was printed and cured over the capacitors prepared on alumina substrates as described in Example 2. To evaluate the encapsulant stability in the presence of strong acids and bases, selected coupons were then dipped in a 30% sulfuric acid solution at 45°C for 2 minutes, rinsed with deionized water, then dried at 120°C for 30 minutes. Additional coupons were exposed to a 30% sodium hydroxide bath at 60°C for 5 minutes. After exposure, these coupons were also rinsed with deionized water and dried prior to testing. The table below summarizes capacitor properties before and after acid and base exposure.

| **Condition** | **Capacitance (nF)** | **Dissipation Factor (%)** | **Insulation Resistance (Gohm)** |
|---|---|---|---|
| After encapsulation | 35.2 | 1.4 | 5.1 |
| After base treatment | 34.5 | 1.5 | 4.4 |
| After acid treatment | 35.2 | 1.4 | 3.9 |

### Example 18

An encapsulant was prepared with the same composition as described in example 15 except the Degussa R7200 fumed silica was substituted by Cabot Cab-O-Sil TS-500 fumed silica. The encapsulant was prepared according to the procedure outlined in Example 2.

The encapsulant was printed and cured over the capacitors prepared on alumina substrates as described in Example 2. To evaluate the encapsulant stability in the presence of strong acids and bases, selected coupons were then dipped in a 30% sulfuric acid solution at 45°C for 2 minutes, rinsed with deionized water, then dried at 120°C for 30 minutes. Additional coupons were exposed to a 30% sodium hydroxide bath at 60°C for 5 minutes. After exposure, these coupons were also rinsed with deionized water and dried prior to testing. The table below summarizes capacitor properties before and after acid and base exposure.

| **Condition** | **Capacitance (nF)** | **Dissipation Factor (%)** | **Insulation Resistance (Gohm)** |
|---|---|---|---|
| After encapsulation | 41.4 | 1.4 | 3.6 |
| After base treatment | 40.5 | 1.4 | 3.2 |
| After acid treatment | 41.3 | 1.5 | 3.5 |

### Example 19 - Comparative Example

A paste identical in composition to example 14 was prepared by substituting the Avatrel epoxy resin with SU-8, an epoxidized phenolic resin from Resolution Products based on bisphenol-A. The SD-1819 phenolic resin was replaced with a standard phenol-formaldehyde resin, Epikote 154, also from Resolution products. The solvent, terpineol, was also changed to butyl carbitol to improve the solubility of these selected resins. The recipe is detailed below:

| | |
|---|---|
| SU-8 Epoxy resin | 5.0g |
| Epikote 154 phenolic resin | 5.0g |
| Butyl carbitol acetate solvent | 14.8g |
| Cabot Cab-O-Sil TS-500 fumed silica | 2.4g |
| Organosiloxane processing aid | 0.2g |
| Benzyldimethylammonium acetate | 0.12g |

The paste was printed, cured and evaluated as illustrated in Example 2. The table below summarizes capacitor properties before and after acid and base exposure.

| **Condition** | **Capacitance (nF)** | **Dissipation Factor (%)** | **Insulation Resistance (Gohm)** |
|---|---|---|---|
| After encapsulation | 38.2 | 1.5 | 3.1 |
| After base treatment | 36.3 | 1.8 | 0.08 |
| After acid treatment | 35.6 | 1.7 | 0.06 |

Three inch squares of the encapsulant paste were also printed and cured on 6" square one oz. (28.3 g) copper sheets to yield defect-free coatings suitable for corrosion resistance testing as described above. The coatings were exposed for 12 hours to a 3% NaCl solution under 2V and 3V DC bias. The corrosion resistance decreased from greater than 7x10⁹ ohms.cm² to 7x10⁵ ohms.cm² at 0.01 Hz, during the test, indicating a substandard encapsulant.

### Example 20 - Comparative Example

A paste identical in composition to Example 14 was prepared by substituting the Avatrel epoxy resin with SU-8, an epoxidized phenolic resin from Resolution Products based on bisphenol-A. The SD-1819 phenolic resin was replaced with a conventional cresol novolac resin, also from Resolution products, known at Epikote 156. The solvent, terpineol, was also changed to butyl carbitol to improve the solubility of these selected resins. A detailed list of ingredients is summarized below.

| | |
|---|---|
| SU-8 Epoxy resin | 5.0g |
| Epon 164 cresol novolac resin | 5.0g |
| Butyl carbitol acetate solvent | 14.8g |
| Cabot Cab-O-Sil TS-500 fumed silica | 2.4g |
| Organosiloxane processing aid | 0.2g |
| Benzyldimethylammonium acetate | 0.12g |

The paste was printed, cured and evaluated as illustrated in Example 2. The table below summarizes capacitor properties before and after acid and base exposure.

| **Condition** | **Capacitance (nF)** | **Dissipation Factor (%)** | **Insulation Resistance (Gohm)** |
|---|---|---|---|
| After encapsulation | 37.2 | 1.4 | 2.8 |
| After base treatment | 35.1 | 1.7 | 0.09 |
| After acid treatment | 36.9 | 1.9 | 0.10 |

### Example 21

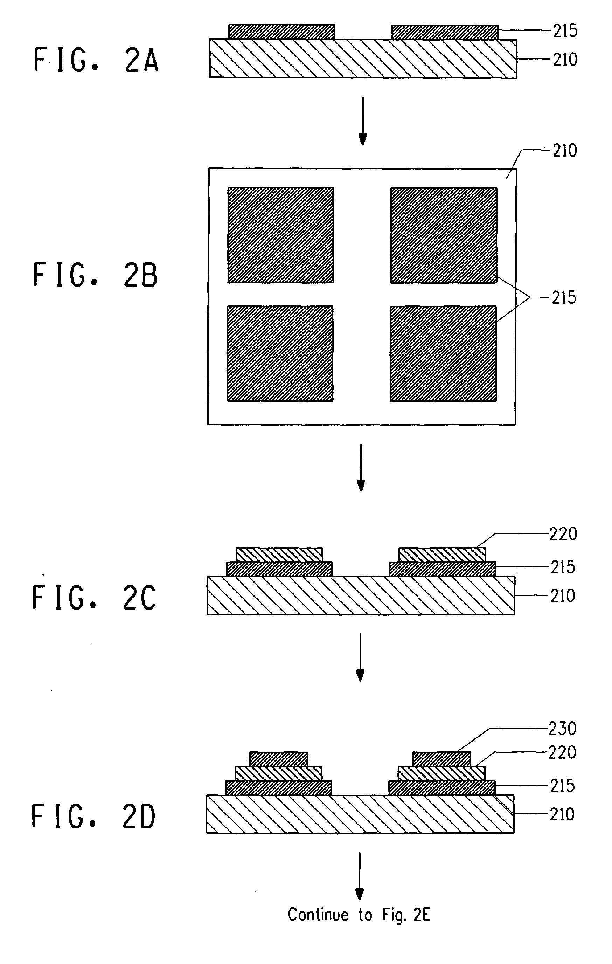

Fired-on-foil capacitors were fabricated for use as a test structure using the following process. As shown in FIG. 2A, a 1 ounce (28.3 g) copper foil **210** was pretreated by applying copper paste EP 320 (obtainable from DuPont Electronics) as a preprint to the foil to form the pattern **215** and fired at 930°C under copper thick-film firing conditions. Each preprint pattern was approximately 1.67 cm by 1.67 cm. A plan view of the preprint is shown in FIG. 2B.

As shown in FIG. 2C, dielectric material (EP 310 obtainable from DuPont Electronics) was screen-printed onto the preprint of the pretreated foil to form pattern **220.** The area of the dielectric layer was 1.22 cm by 1.22.cm. and within the pattern of the preprint. The first dielectric layer was dried at 120°C for 10 minutes. A second dielectric layer was then applied, and also dried using the same conditions.

As shown in FIG. 2D, copper paste EP 320 was printed over the second dielectric layer and within the area of the dielectric to form electrode pattern **230** and dried at 120°C for 10 minutes. The area of the electrode was 0.9 cm by 0.9 cm.

The first dielectric layer, the second dielectric layer, and the copper paste electrode were then co-fired at 930°C under copper thick-film firing conditions.

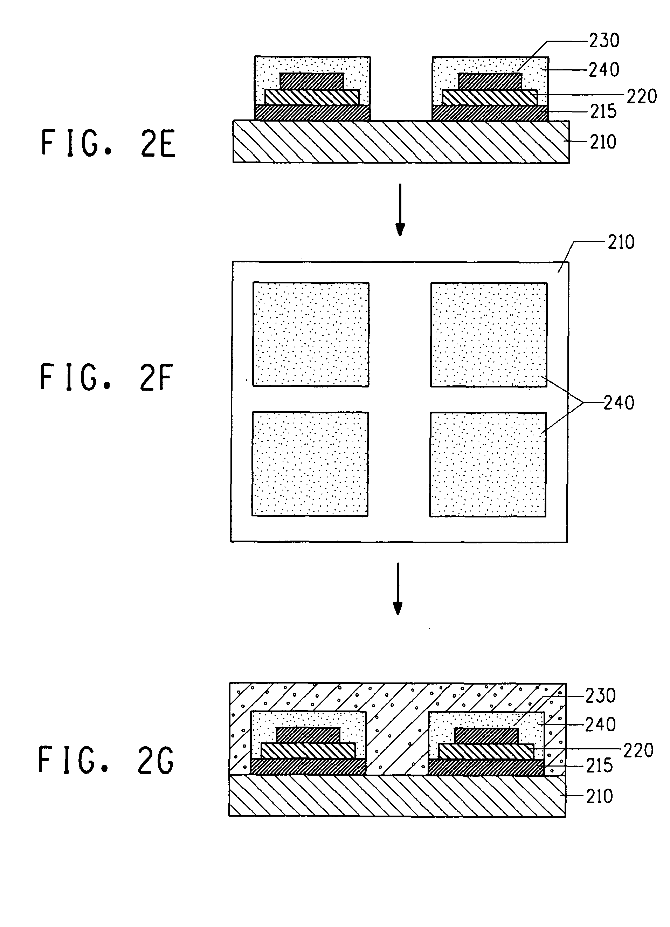

The encapsulant composition as described in Example 2 was printed through a 165 mesh screen over capacitors to form encapsulant layer **240** using the pattern as shown in FIG. 2E. The encapsulant was dried and cured using various profiles. The cured encapsulant thickness was approximately 13 µm. A plan view of the structure is shown in FIG. 2F. The component side of the foil was laminated to 1080 BT resin prepreg **250** at 375°F (191°C) at 400 psi (2.76 x 10⁶ Pa) for 90 minutes to form the structure shown in FIG. 2G. The adhesion of the prepreg to the encapsulant was tested using the IPC - TM 650 adhesion test number 2.4.9. The adhesion results are shown below:

| **Cure Cycle** | **Encapsulant over Cu (Ib force/inch (kg force/cm))** | **Encapsulant over Capacitor (Ib force/inch (kg force/cm))** |
|---|---|---|
| 190°C/30 mins | 1.2 (0.21) | 3.1 (0.55) |
| 190C°/45 mins. | 1.0 (0.18) | 3.1 (0.55) |
| 170°C/45 mins. | 1.0 (0.18) | 1.5 (0.27) |
| 120°C/60 mins | 1.2 (0.21) | 3.1 (0.55) |
| 170°C/90 mins | 1.2 (0.21) | 3.1 (0.55) |
| 200°C/5 mins | 1.2 (0.21) | 3.1 (0.55) |

showing that the adhesion over the capacitor and to the prepreg was quite acceptable.

### Examples 22 and 23 - Comparative Examples

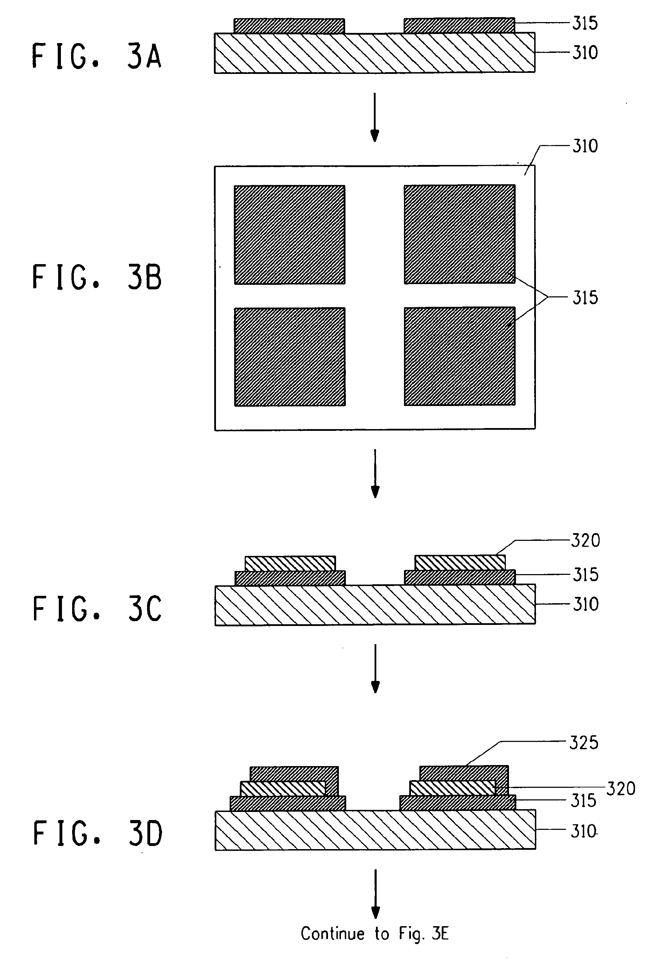

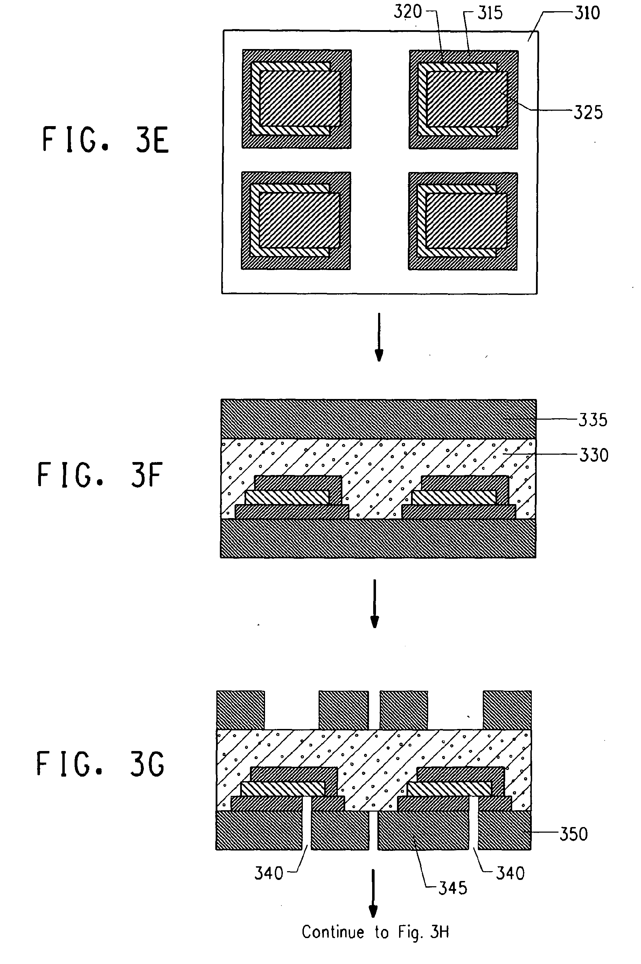

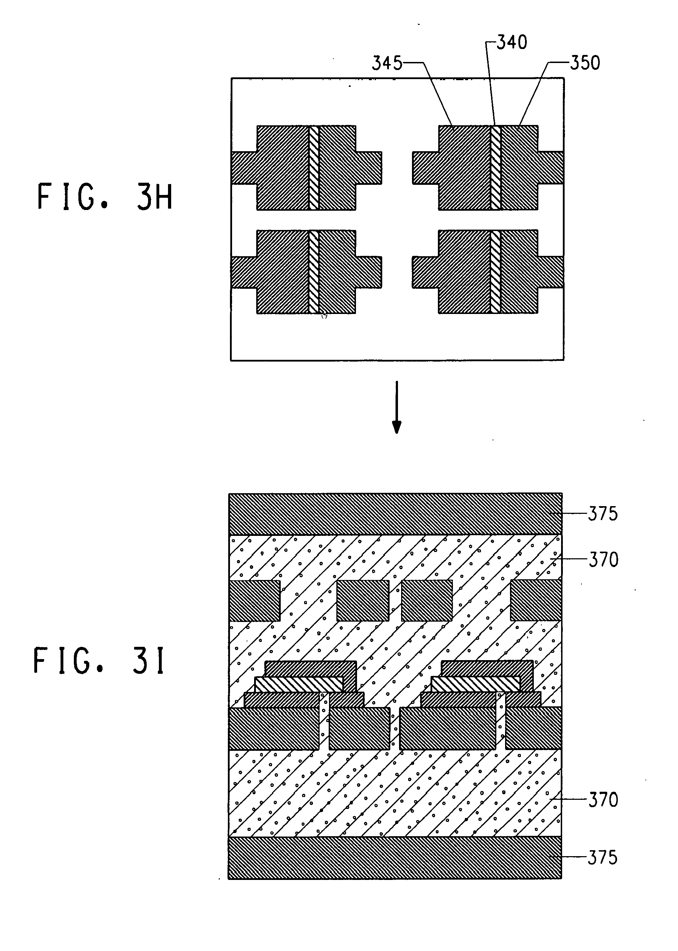

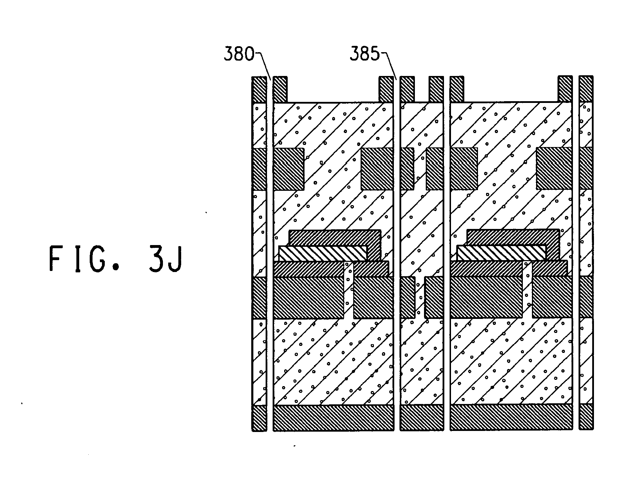

Printed wiring boards were manufactured with embedded fired-on-foil ceramic capacitors without use of an organic encapsulant. Some of the fired-on-foil capacitors were exposed to a brown oxide treatment, some were not. The printed wiring boards were fabricated, according to the process described below and as shown schematically in FIG. 3A - 3J.

As shown in FIG. 3A, a 1 ounce (28.3 g) copper foil **310** was pretreated by applying copper paste EP 320 (obtainable from DuPont Electronics) as a preprint **315** to the foil and fired at 930°C under copper thick-film firing conditions. Each preprint pattern was approximately 150 mils by 150 mils (3.8 mm by 3.8 mm) and is shown in FIG. 3A in side elevation and as a plan view in FIG. 3B.

As shown in FIG. 3C, dielectric material (EP 310 obtainable from DuPont Electronics) was screen-printed onto the preprint of the pretreated foil to form dielectric layer **320.** The area if the dielectric layer was 100 mils by 100 mils (2.54 mm by 2.54 mm) and within the pattern of the preprint. The first dielectric layer was dried at 120°C for 10 minutes. A second dielectric layer was then applied, and also dried using the same conditions.

As shown in FIG. 3D, copper paste EP 320 was printed over the second dielectric layer and partially over the copper foil to form electrode layer **325** and dried at 120°C for 10 minutes.

The first dielectric layer, the second dielectric layer, and the copper paste electrode layer were then co-fired at 930°C under copper thick-film firing conditions. FIG. 3E is a plan view of the capacitor on foil structure.

In one case, foils were subjected to a brown oxide process to enhance adhesion of the copper foil to the prepreg. In another case, foils were not subjected to the brown oxide treatment prior to lamination.

The fired-on-foil capacitor side of the foil was then laminated with FR4 prepreg **330** using conventional printing wiring board lamination conditions. A copper foil **335** was also applied to the laminate material giving the laminated structure shown in FIG. 3F.

Referring to FIG. 3G, after lamination, a photo-resist was applied to the foils and the foils were imaged, etched using an alkaline etching process and the remaining photoresist stripped using standard printing wiring board processing conditions. The etching produced circuitry on the top foil and a trench **340** in the foil containing the fired-on-foil capacitors which broke electrical contact between the first electrode **310** and the second electrode **325** to form electrodes **345** and **350.** This formed an inner layer panel with embedded fired-on-foil capacitors. FIG. 3H is a plan view of the foil electrode design. As shown in FIG. 31, the inner layer panel was incorporated inside a printed wiring board containing additional prepreg **370** and copper foils **375** using standard multilayer lamination processes. As shown schematically in FIG. 3J, vias **380** and **385** were drilled and plated and the outer copper layers etched and finished with nickel/gold plating to create surface terminals connected to the capacitor.

Insulation resistance of the embedded capacitors were measured and values ranged from 50- 100 Giga ohms.

Printed wiring boards containing the embedded fired-on-foil capacitors that in one case had been subjected to the brown oxide process and in another case had not been subjected to the brown oxide process were placed in an environmental chamber and the capacitors exposed to 85°C, 85% relative humidity and 5 volts DC bias. Insulation resistance of the capacitors were monitored every 24 hours. Failure of the capacitor was defined as a capacitor showing less than 50 mega-ohms in insulation resistance. Capacitors began failing for both cases after 24 hours and 100% of the capacitors for all builds failed after 120 hours.

### Example 24

Printed wiring boards were manufactured with embedded fired-on-foil ceramic capacitors using an organic encapsulant to cover the surface of the capacitor. The printed wiring boards were fabricated, according to the process described below and as shown schematically in FIG. 4A - 4L.

As shown in FIG. 4A, a 1 ounce (28.3 g) copper foil **410** was pretreated by applying copper paste EP 320 (obtainable from DuPont Electronics) as a preprint **415** to the foil and fired at 930°C under copper thick-film firing conditions. Each preprint pattern was approximately 150 mils by 150 mils (3.8 mm by 3.8 mm) and is shown in plan view in FIG. 4B.

As shown in FIG. 4C, dielectric material (EP 310 obtainable from DuPont Electronics) was screen-printed onto the preprint of the pretreated foil to form dielectric layer **420.** The area if the dielectric layer was 100 mils by 100 mils and within the pattern of the preprint. The first dielectric layer was dried at 120°C for 10 minutes. A second dielectric layer was then applied, and also dried using the same conditions.

As shown in FIG. 4D, copper paste EP 320 was printed over the second dielectric layer and partially over the copper foil to form electrode layer **425** and dried at 120°C for 10 minutes.

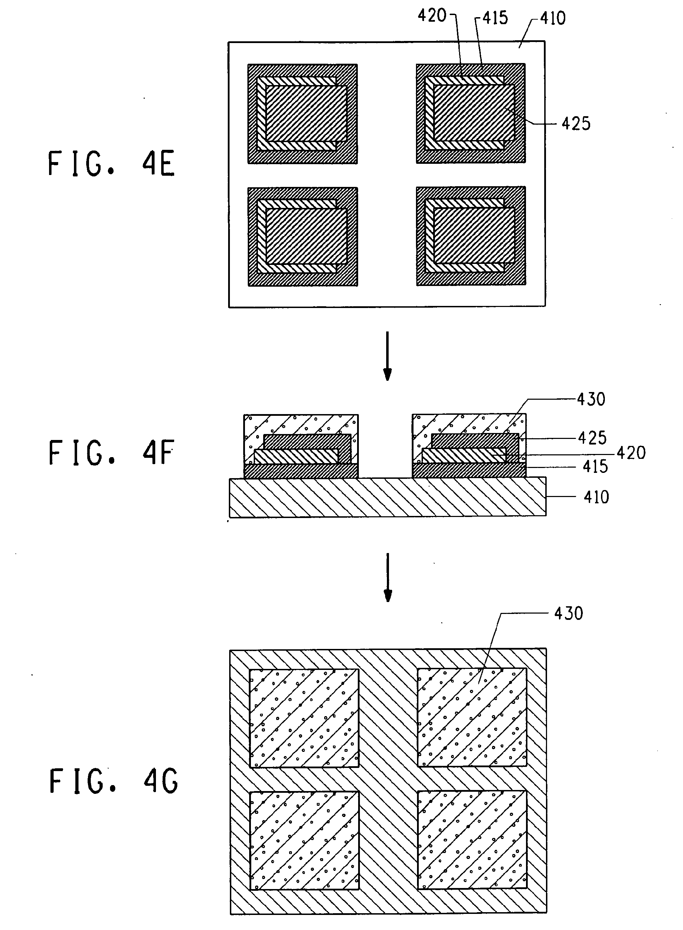

The first dielectric layer, the second dielectric layer, and the copper paste electrode layer were then co-fired at 930°C under copper thick-film firing conditions. FIG. 4E is a plan view of the capacitor on foil structure.

The encapsulant of example 2 was screen printed through a 400 mesh screen over the capacitor electrode and dielectric to form encapsulant layer **430** as shown in side elevation in FIG. 4F and in plan view in FIG. 4G. It was dried for 15 minutes at 120°C. Another layer of encapsulant was printed and dried for 60 minutes at 120°C. The two layers of encapsulant were then cured at 170°C for 90 minutes followed by a short "spike" cure of 15 minutes at 200°C.

The fired-on-foil and organic encapsulant side of the foil was then laminated with FR4 prepreg **435** using conventional printing wiring board lamination conditions. No chemical brown or black oxide treatment was applied to the copper foil prior to lamination. A copper foil **440** was also applied to the laminate material giving the laminated structure shown in FIG. 4H.

Referring to FIG. 41, after lamination, a photo-resist was applied to the foils and the foils were imaged, etched with alkaline etching processes and the remaining photoresist stripped using standard printing wiring board processing conditions. The etching produced a trench **450** in the foil containing the fired-on-foil capacitors which broke electrical contact between the foil electrode **410** and the second electrode **425** and formed electrodes **455** and **465** and an inner layer panel with embedded fired-on-foil capacitors. FIG. 4J is a plan view of the electrodes formed from the foil containing the fired-on-foil capacitors. In FIG. 4K, the inner layer panel was incorporated inside a printed wiring board by lamination with additional prepreg **460** and copper foil **470** using standard multilayer lamination processes. As shown schematically in FIG. 4L, vias **480** and **485** were drilled and plated and the outer copper layers etched and finished with nickel/gold plating to create surface terminals connected to the capacitor.

Insulation resistance of the capacitors were measured and values ranged from 50-100 giga ohms.

The printed wiring board was placed in an environmental chamber and the capacitors exposed to 85°C, 85% relative humidity and 5 volts DC bias. Insulation resistance of the capacitors were monitored every 24 hours. Failure of the capacitor was defined as a capacitor showing less than 50 mega-ohms in insulation resistance. Capacitors survived 1000 hours without any noticeable degradation of insulation resistance.

### Example 25

Printed wiring boards were manufactured with embedded ceramic fired-on-foil capacitors on the outer layers of the printed wiring board rather than completely embedded. In this case, the organic encapsulant was applied over the fired-on-foil capacitor and into the etched trench. The printed wiring boards were fabricated, according to the process described below and as shown in FIG. 5A - 5M.

As shown in FIG. 5A, a 1 ounce (28.3 g) copper foil **510** was pretreated by applying copper paste EP 320 (obtainable from DuPont Electronics) as a preprint **515** to the foil and fired at 930°C under copper thick-film firing conditions. The preprint covered the entirety of the copper foil and a plan view is shown schematically in FIG 5B.

As shown in FIG. 5C, dielectric material (EP 310 obtainable from DuPont Electronics) was screen-printed onto the preprint of the pretreated foil to form dielectric layer **520.** The area if the dielectric layer was approximately 50 mils by 50 mils (1.27 mm by 1.27 mm). The first dielectric layer was dried at 120°C for 10 minutes. A second dielectric layer was then applied, and also dried using the same conditions.

As shown in FIG. 5D, copper paste EP 320 was printed over the second dielectric layer and partially over the preprinted copper foil to form electrode layer **525** and dried at 120°C for 10 minutes.

The first dielectric layer, the second dielectric layer, and the copper paste electrode were then co-fired at 940°C under copper thick-film firing conditions. FIG. 5E is a plan view of the capacitor structure.

The encapsulant of example 2 was screen printed through a 400 mesh screen over the capacitor electrode and dielectric as shown in side elevation in FIG. 5F and in plan view in 5G to form encapsulant layer **530.** It was dried for 10 minutes at 120°C. Another layer of encapsulant was printed and dried for 60 minutes at 120°C. The two layers of encapsulant were then cured at 150°C for 90 minutes followed by a short "spike" cure of 15 minutes at 200°C.

The copper foil containing the encapsulated fired-on-foil capacitors was subjected to a brown oxide treatment to enhance the adhesion of the copper foil to the prepreg material.

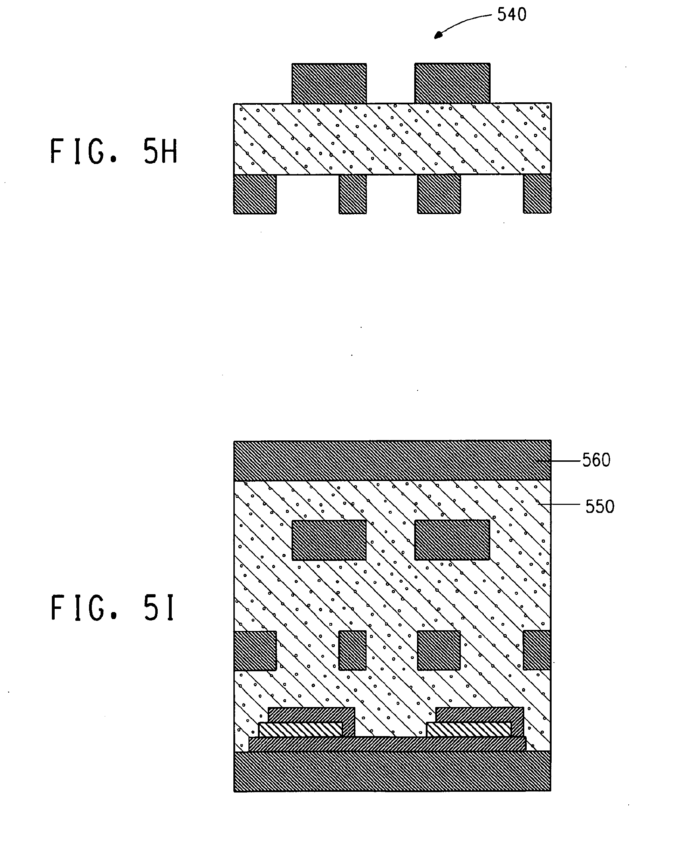

As shown in FIG. 5H, inner layer structure **540** was manufactured separately using prepreg and copper foils, patterned and etched using standard printed wiring board processes.

The foil containing the encapsulated fired-on-foil capacitors was then laminated with FR4 prepreg with inner layer **540** and an additional laminate layer **550** and copper foil **560** to form the structure shown in FIG 5I.

Referring to FIG. 5J, vias **580** were drilled and plated and the outer foils etched with alkaline etching processes and finished with nickel gold plating. The etching produced circuitry on the top foil and a trench **570** in the foil containing the fired-on-foil capacitors which broke electrical contact between the foil electrode **510** and the second electrode **525** to form electrodes **575** and **576.** FIG. 5K is a plan view of the etched foil containing the fired-on-foil capacitors.

Referring to FIG. 5L, after forming the trench **570** in the outer foil, the encapsulant used in Example 2 was printed into the trench using a 180 mesh screen to form the structure **585.** The encapsulant was dried for 10 minutes at 120°C. A second encapsulant printing was performed using the same printing conditions to insure the trench was fully filled and that part of the copper foil surrounding the trench was coated by the encapsulant. The second layer was also dried at 120°C for 10 minutes. The encapsulant was then cured for 90 minutes at 150°C followed by a spike cure at 200°C for 15 minutes. A plan view of the structure is shown in FIG. 5M.

Finally, soldermask was applied to the outer surfaces to create the finished printed circuit board.

Insulation resistance of the capacitors were measured and values ranged from 10 giga-ohms to greater than 50 giga ohms.

The printed wiring board was placed in an environmental chamber and the capacitors exposed to 85°C, 85% relative humidity and 5 volts DC bias. Insulation resistance of the capacitors were monitored every 24 hours. Failure of the capacitor was defined as a capacitor showing less than 50 mega-ohms in insulation resistance. All capacitors survived 1000 hours without any noticeable degradation of insulation resistance.

## Claims

1. A composition comprising:
one or more epoxy-containing cyclic olefin resins having water absorption of 2% or less,
one or more phenolic resins having water absorption of 2% or less,
an epoxy catalyst, and
an organic solvent,
wherein the epoxy-containing cyclic olefin resin is epoxy polynorbornene comprising molecular units of formulas I and II: 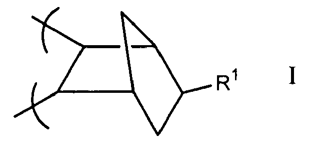 wherein R¹ is independently selected from hydrogen and a (C₁-C₁₀) alkyl and 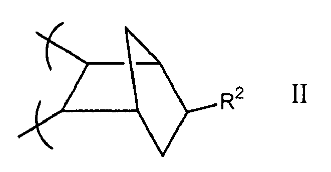 wherein R² is a crosslinkable epoxy group, and the molar ratio of molecular units of formula II to formula I is greater than 0 and up to about 0.4.

2. The composition of claim 1, further comprising one or more crosslinking agents which includes a dicyclopentadiene phenolic resin, and resins of cyclolefins condensed with phenolics,
wherein the dicyclopentadiene phenolic resin has a structure of formula III, 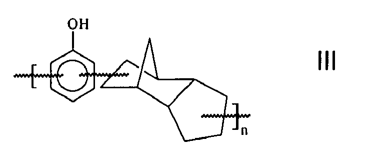 and,
wherein the epoxy catalyst is selected from either dimethylbenzylamine or dimethylbenzylammonium acetate.

3. The composition of any preceding claim, wherein the epoxy-containing cyclic olefin resins have water absorption of 1% or less and the phenolic resins have water absorption of 1 % or less.

4. The composition of any preceding claim, further comprising one or more inorganic functional fillers, defoamers and colorants, wherein said inorganic functional fillers are selected from the group consisting of metals, metal compounds and electrically-insulating fillers selected from the group consisting of titanium dioxide, alumina, talc and fumed silica.

5. The composition of any preceding claim having a cure temperature of up to 270°C in a short infrared cure or a cure temperature of 190°C or less in a curing profile.

6. The use of the composition of claims 1 - 5 as a protecting encapsulant for ceramic capacitors when immersed in 30% sulfuric acid or 30% sodium hydroxide and wherein the encapsulant exhibits a peel strength over the capacitor of greater than 2 pounds per inch (0.36 kg force/cm).

7. The use of the composition of claims 1 - 5 as a protecting encapsulant for ceramic capacitors for greater than 1000 hrs during an accelerated life test of exposure to humidity, elevated temperature and DC bias.

8. The use of the composition of claims 1 - 5 to fill an etched trench.

9. The use of claim 8, wherein the etched trench isolates the top and bottom electrodes of an embedded capacitor.

10. The use of the composition of claims 1 - 5 as protection of any electrical or non-electrical component in integrated circuit packaging and in wafer-level packaging; or
as a component in or as
a semiconductor junction coating,
a semiconductor stress buffer,
an interconnect dielectric,
a solder bump underfill,
a protective overcoat for bond pad redistribution, and
"glob top" protective encapsulation of semiconductors.

11. An embedded fired-on-foil ceramic capacitor comprising a capacitor and a prepreg and which is embedded in a printed wiring board or on IC package substrate, and wherein the said fired-on-foil ceramic capacitor is coated with a composition as defined in any of claims 1 to 5.

12. A method of making an encapsulant composition comprising:
combining
one or more epoxy-containing cyclic olefin resins having water absorption of less than 2%,
one or more phenolic resins having a water absorption of 2% or less,
an epoxy catalyst,
one or more inorganic, electrically insulating fillers,
a defoamer and
an organic solvent
to provide an encapsulant composition;
applying the encapsulant composition to a substrate; and
curing the applied encapsulant composition
in a short infrared cure at a cure temperature of up to 270°C or
in a curing profile at a cure temperature of 190°C or less,
wherein the epoxy-containing cyclic olefin resin is an epoxy polynorbornene, and
wherein the crosslinking agent is selected from the group of dicyclopentadiene phenolic resin and resins of cyclolefins condensed with phenolics or mixtures thereof.
